# EUROPEAN PATENT APPLICATION

(11) **EP 4 760 304 A1**
(43) Date of publication of application: **17.06.2026**
(21) Application number: 25216935.4
(22) Date of filing: 19.11.2025
(51) Int. Cl.: G01R 31/389

(54) **METHOD AND APPARATUS FOR OBTAINING BATTERY STATE INFORMATION**

(30) Priority: 16.12.2024 KR 20240187346
(71) Applicant: SAMSUNG SDI CO., LTD., Yongin-si, Gyeonggi-do 17084 (KR)
(72) Inventor: KANG, Taehyeon, 17084 Yongin-si, Gyeonggi-do (KR)
(74) Representative: Gulde & Partner

(57) **Abstract**

Provided are a method and apparatus for obtaining battery state information, the method including controlling a pulse generator to supply a pulse of a frequency to battery modules, calculating an impedance value corresponding to the frequency at a same time a battery including the battery modules is charged based on voltage measurement information and current measurement information corresponding to the pulse obtained in real time, and obtaining the battery state information based on the impedance value.

## Description

Various aspects of the present disclosure relates to a method and apparatus for obtaining battery state information.

### RELATED ART

Electrochemical impedance spectroscopy (hereinafter, EIS) analysis for measuring an impedance value of a battery and performing electrochemical analysis by using the measured impedance value may be used as a method of diagnosing a state of a battery, whether or not the battery is defective, and the like.

In the related art, for EIS analysis as described above, additional power may be suitably supplied separately from a charging voltage/current of a battery.

In addition, a circuit for individual EIS analysis may be suitably designed in units of modules.

The information described above in the background art of the disclosure is only intended to improve understanding of the background of the disclosure, and may include information that does not constitute related art.

### SUMMARY

Provided are a method and apparatus for obtaining battery state information by using an impedance value calculated at the same time as a battery is charged. Thus, very reliable and precise battery state information can be revealed. Also provided is a computer-readable recording medium having recorded thereon a program for causing a computer to execute the above method.

However, the aspects of the present disclosure are not limited to those described above, and other aspects not mentioned may be clearly understood by those skilled in the art from the description of the disclosure described below.

According to an aspect of the disclosure, a method of obtaining battery state information includes controlling a pulse generator to supply a pulse of a frequency to battery modules, calculating an impedance value corresponding to the frequency at a same time a battery including the battery modules is charged based on voltage measurement information and current measurement information corresponding to the pulse obtained in real time, and obtaining the battery state information based on the impedance value.

The method may further include continuously changing the frequency based on a user-defined value. Preferably, the change of frequency is in the range of 1 Hz to several kHz.

The controlling the pulse generator may include generating a current pulse corresponding to the frequency continuously changing, and supplying the current pulse to the battery modules.

The voltage measurement information may correspond to cells in the battery modules, and is obtained from an apparatus configured to control the battery modules.

The current measurement information may be obtained from at least one of the pulse generator or a measurement sensor.

The voltage measurement information may include phase information and amplitude information regarding a voltage corresponding to the pulse, wherein the current measurement information includes phase information and amplitude information regarding a current corresponding to the pulse.

The obtaining the battery state information may include deriving a Nyquist graph based on the impedance value, and obtaining the battery state information based on a result of comparing the Nyquist graph with a stored Nyquist graph.

The method may further include differently calculating impedance values including the impedance value for frequencies including the frequency.

The battery state information may correspond to the pulse of the frequency supplied to the battery modules.

The battery state information may include at least one of state of charge (SOC) information regarding the battery, state of health (SOH) information regarding the battery, deterioration information regarding the battery, or internal resistance information regarding the battery.

According to another aspect of the disclosure, a computer-readable recording medium has recorded thereon a program for causing a computer to execute a method of obtaining battery state information by controlling a pulse generator to supply a pulse of a frequency to battery modules, calculating an impedance value corresponding to the frequency at a same time a battery including the battery modules is charged based on voltage measurement information and current measurement information corresponding to the pulse obtained in real time, and obtaining the battery state information based on the impedance value.

According to another aspect of the disclosure, an apparatus for obtaining battery state information includes a memory for storing at least one program, and at least one processor configured to execute the at least one program to control a pulse generator to supply a pulse of a frequency to battery modules, calculate an impedance value corresponding to the frequency based on voltage measurement information and current measurement information corresponding to the pulse obtained in real time at a same time as a battery is charged, and obtain the battery state information based on the impedance value.

The frequency may be continuously changed based on a user-defined value.

The at least one processor may be further configured to execute the at least one program to generate a current pulse corresponding to the frequency continuously changing, and supply the current pulse to the battery modules.

The voltage measurement information may correspond to cells in the battery modules, and may be obtained from an apparatus configured to control the battery modules.

The current measurement information may be obtained from at least one of the pulse generator or a measurement sensor.

The voltage measurement information may include phase information and amplitude information regarding a voltage corresponding to the pulse, wherein the current measurement information includes phase information and amplitude information regarding a current corresponding to the pulse.

The at least one processor may be further configured to execute the at least one program to obtain the battery state information by using the pulse of the frequency supplied to the battery modules.

The at least one processor may be further configured to execute the at least one program to obtain the battery state information corresponding to impedance values including the impedance value that are calculated differently for frequencies including the frequency.

The at least one processor may be further configured to derive a Nyquist graph based on the impedance value, and obtain the battery state information based on a result of comparing the Nyquist graph with a stored Nyquist graph.

### BRIEF DESCRIPTION OF THE DRAWINGS

The following drawings attached to the description illustrate embodiments and make the scope of the disclosure to be further understood together with the detailed description of the disclosure described below, and thus, the disclosure should not be construed as being limited to the matters described in the drawings in which:
FIG. 1 is a view illustrating an example of a method of obtaining battery state information by using an impedance value calculated at the same time as a battery is charged, according to one or more embodiments;
FIG. 2 is a block diagram illustrating an example of an apparatus for obtaining battery state information by using an impedance value calculated at the same time as a battery is charged, according to one or more embodiments;
FIG. 3 is a flowchart illustrating an example of a method of obtaining battery state information by using an impedance value calculated at the same time as a battery is charged, according to one or more embodiments;
FIG. 4 is a view illustrating an example of a method of controlling a pulse generator, according to one or more embodiments;
FIG. 5 is a view illustrating an example of voltage measurement information and current measurement information according to one or more embodiments; and
FIG. 6 is a view illustrating an example of a method of obtaining battery state information, according to one or more embodiments.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection.

For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer, or section described below could be termed a second element, component, region, layer, or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same." In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

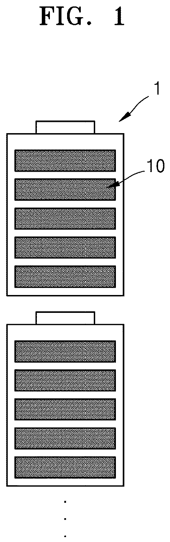

Hereinafter, the disclosure is described in detail with reference to the accompanying drawings. A method of obtaining battery state information by using an impedance value calculated at the same time as a battery is charged, according to one or more embodiments, is described in more detail with reference to FIGS. 1 to 6. However, embodiments may be implemented in various different forms and are not limited to examples described herein.

FIG. 1 is a view illustrating an example of a method of obtaining battery state information by using an impedance value calculated at the same time as a battery is charged, according to one or more embodiments.

Hereinafter, an example of a method of obtaining battery state information by using an impedance value calculated at the same time as a battery is charged is briefly described with reference to FIG. 1.

Referring to FIG. 1, one battery module 1 may include a plurality of battery cells 10.

As charging and discharging of a battery are repeatedly performed, performance of the plurality of battery cells 10 may be degraded. In one or more embodiments, a user may diagnose performance of the battery by performing electrochemical impedance spectroscopy (EIS) analysis by using information regarding each of the battery cells 10.

The EIS analysis may refer to an analysis method of evaluating electrochemical properties of a battery, and may refer to a method of analyzing impedance according to a frequency by applying an alternating current voltage to a battery, and by measuring a resulting current reaction. In some embodiments, different physical and chemical reactions may occur inside the battery respectively in a low frequency domain and in a high frequency domain, and thus, the performance of the battery may be diagnosed by performing EIS analysis at various frequencies.

For example, the performance of the battery may be diagnosed by obtaining voltage information and current information regarding each of the battery cells 10, calculating an impedance value, and performing EIS analysis by using the calculated impedance value.

In some embodiments, a graph, a circuit model, and the like for diagnosing the performance of the battery may be derived by using the calculated impedance value, and the EIS analysis may be performed by using the derived graph, a circuit model, and the like.

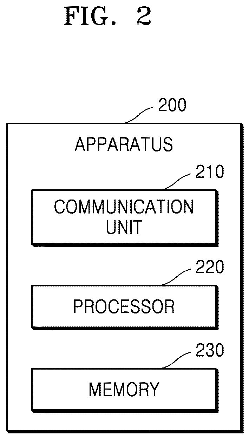

FIG. 2 is a block diagram illustrating an example of an apparatus 200 for obtaining battery state information by using an impedance value calculated at the same time as a battery is charged, according to one or more embodiments.

Referring to FIG. 2, an apparatus 200 for obtaining battery state information by using an impedance value calculated at the same time as a battery is charged (hereinafter, an apparatus) may include a communication unit 210, a processor 220, and a memory 230. The apparatus 200 of FIG. 2 may include only components related to embodiments of the present disclosure, for example. In one or more embodiments, it is obvious to those skilled in the art that other general-purpose components may be further included in addition to the components illustrated in FIG. 2.

The communication unit 210 may include one or more components that allow wired/wireless communication to be performed with an external server or with an external apparatus. For example, in one or more embodiments, the communication unit 210 may include a short-range communicator, a mobile communicator, and the like for communication with the external server or the external apparatus.

The memory 230 may be hardware that stores various types of data processed within the apparatus 200, and may store a program for processing and controlling by the processor 220.

For example, the memory 230 may store various types of data, such as a user-defined value (e.g., a preset user-defined value) for changing a frequency, voltage measurement information, current measurement information, battery state information, and data generated according to an operation of the processor 220. In some embodiments, the memory 230 may store an operating system (OS) and at least one program (e.g., a program suitable for a processor to operate, and the like).

The memory 230 may include random access memory (RAM), such as dynamic random access memory (DRAM) or static random access memory (SRAM), read-only memory (ROM), electrically programmable read-only memory (EEPROM), CD-ROM, Blu-ray or other optical disk storage, a hard disk drive (HDD), a solid state drive (SSD), flash memory, or the like.

The processor 220 may control the overall operation of the apparatus 200. For example, in one or more embodiments, the processor 220 may generally control an input unit, a display, the communication unit 210, the memory 230, and the like by executing programs stored in the memory 230.

The processor 220 may be implemented by using at least one of application specific integrated circuits (ASICs), digital signal processors (DSPs), digital signalprocessing devices (DSPDs), programmable logistical devices (PLDs), field programmable gate arrays (FPGAs), controllers, micro-controller units, microprocessors, or other electrical units for performing functions.

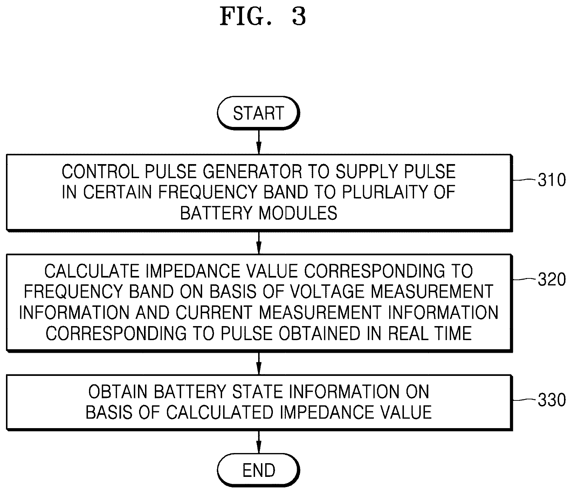

The processor 220 may control the operation of apparatus 200 by executing the programs stored in memory 230. For example, the processor 220 may perform at least a portion of a method of obtaining battery state information by using an impedance value calculated at the same time as a battery is charged, which is described with reference to FIGS. 3 to 6.

FIG. 3 is a flowchart illustrating an example of a method of obtaining battery state information by using an impedance value calculated at the same time as a battery is charged, according to one or more embodiments.

Hereinafter, an example of a method of obtaining battery state information by using an impedance value calculated at the same time as a battery is charged is described with reference to FIG. 3.

Referring to FIG. 3, the method of obtaining battery state information by using an impedance value calculated at the same time as a battery is charged may include operations 310, 320, and 330. However, the disclosure is not limited thereto, and other general-purpose operations may be further included in the method of obtaining battery state information by using an impedance value calculated at the same time as a battery charged, in addition to the operations illustrated in FIG. 3. In some embodiments, as described above with reference to FIGS. 1 and 2, at least one of the operations in the flowchart illustrated in FIG. 3 may be processed by a processor.

In operation 310, the processor may control a pulse generator to supply a pulse of a corresponding frequency (e.g., a certain frequency) to a plurality of battery modules. In some embodiments, the corresponding frequency may be continuously changed on the basis of a user-defined value.

For example, the processor may generate a current pulse corresponding to the frequency that is continuously changed, and may supply the generated current pulse to each of the plurality of battery modules.

In operation 320, the processor may calculate an impedance value corresponding to the frequency on the basis of voltage measurement information and current measurement information corresponding to the pulse obtained in real time. In some embodiments, the voltage measurement information may include voltage measurement information regarding each of a plurality of cells included in each of the battery modules.

For example, the voltage measurement information may be obtained from a corresponding apparatus (e.g., certain apparatus) for controlling the battery modules. In some embodiments, the voltage measurement information may be obtained from a separate apparatus. In some embodiments, the current measurement information may be obtained from at least one of the pulse generator or a measurement sensor.

For example, the voltage measurement information may include phase information and amplitude information regarding a voltage corresponding to the pulse, and the current measurement information may include phase information and amplitude information regarding a current corresponding to the pulse.

In operation 330, the processor may obtain battery state information on the basis of the impedance value.

For example, the processor may obtain the battery state information corresponding to the corresponding frequency on the basis of the impedance value calculated differently for each corresponding frequency.

For example, the processor may derive a Nyquist graph 620 on the basis of the calculated impedance value, and may obtain the battery state information on the basis of the result of comparing the derived Nyquist graph 620 with a pre-stored Nyquist graph 610. In some embodiments, the battery state information may include at least one of state of charge (SOC) information regarding the battery, state of health (SOH) information regarding the battery, deterioration information regarding the battery, or internal resistance information regarding the battery.

In some embodiments, the processor may obtain the battery state information by using the pulse of the corresponding frequency supplied to the plurality of battery modules. In some embodiments, if no separate power for obtaining the battery state information is present, the processor may obtain the battery state information by using power supplied to the battery modules.

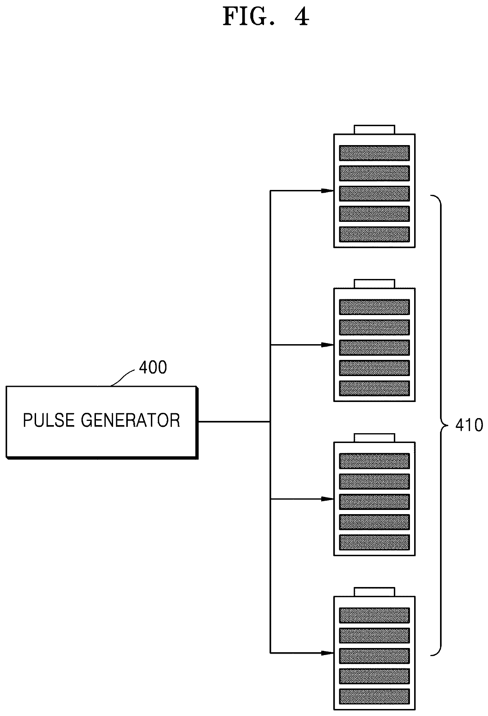

FIG. 4 is a view illustrating an example of a method of controlling a pulse generator, according to one or more embodiments.

Hereinafter, an example of a method by which a processor controls a pulse generator is described with reference to FIG. 4.

Referring to FIG. 4, a processor may control a pulse generator 400 to supply a pulse to a plurality of battery modules 410. In some embodiments, the pulse generator 400 may refer to an apparatus that applies a current or voltage pulse to the plurality of battery modules 410 in a certain period or pattern.

For example, the processor may control the pulse generator 400 to supply a pulse of a corresponding frequency to the plurality of battery modules 410. In some embodiments, the corresponding frequency may be continuously changed on the basis of a user-defined value.

For example, the processor may control the pulse generator 400 by using a pulse frequency modulation (PFM) control method. In some embodiments, the PFM control method may refer to a method of controlling an output signal of a pulse generator, and may refer to a method of changing a frequency of a pulse while maintaining a magnitude of an output current or output voltage constant.

For example, if power is input from a power source to the pulse generator 400, the processor may control the pulse generator 400 to convert the input power into direct current power.

For example, the processor may control the pulse generator 400 to generate a pulse by using the PFM control method described above. As an example, the processor may control the pulse generator 400 to maintain an output voltage constant, may change a frequency, and may generate an output current pulse changing according to the frequency that changes. As another example, the processor may control the pulse generator 400 to maintain an output current constant, may change a frequency, and may generate an output voltage pulse changing according to the frequency that changes.

For example, the corresponding frequency may be continuously changed on the basis of a user-defined value and may be changed within a range of several Hz to several kHz. In some embodiments, the user-defined value may include a set value for changing a frequency from a small frequency to a large frequency or a set value for changing a frequency from a large frequency (for example in the range of 1-10 kHz) to a small frequency (for example in the range of 1-10 Hz), but is not limited thereto. In one or more embodiments, the corresponding frequency may be changed in real time on the basis of a state of a battery module.

In one or more embodiments, the processor may control the pulse generator 400 to generate a current pulse corresponding to a frequency that is continuously changed, and may supply the generated current pulse to each of the plurality of battery modules 410.

For example, the processor may obtain, in real time, information by measuring a voltage corresponding to the current pulse supplied by the pulse generator 400 and information by measuring a current corresponding to the current pulse supplied by the pulse generator 400.

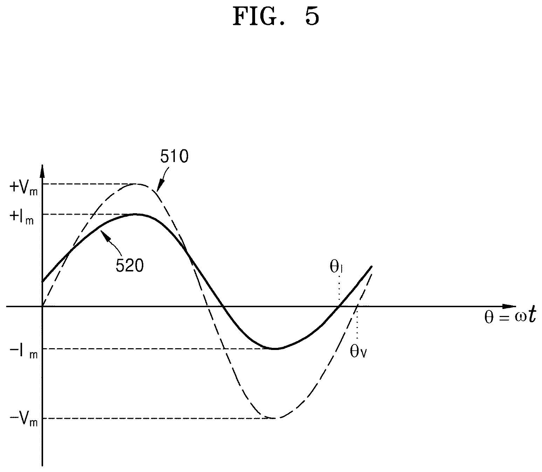

FIG. 5 is a view illustrating an example of voltage measurement information and current measurement information for calculating an impedance value, according to one or more embodiments.

Hereinafter, an example of a method by which a processor calculates an impedance value on the basis of voltage measurement information and current measurement information is described with reference to FIG. 5.

Referring to FIG. 5, a processor may obtain voltage measurement information 510 and current measurement information 520.

For example, the processor may obtain the voltage measurement information 510 from a corresponding apparatus that controls a plurality of battery modules. In some embodiments, the corresponding apparatus that controls the plurality of battery modules may refer to an analog front end (AFE), and the AFE may refer to an apparatus that measures an analog signal, such as a voltage, a current, and/or a temperature of a battery cell 10, that converts the measured analog signal into a digital signal, and that provides the digital signal to other apparatuses, such as a battery management system (BMS).

In one or more embodiments, the processor may obtain the voltage measurement information 510 regarding each of a plurality of battery cells 10 from the corresponding apparatus (e.g., the AFE).

For example, the processor may obtain the current measurement information 520 from at least one of a pulse generator or a measurement sensor.

As an example, the processor may maintain an output voltage constant from the pulse generator, may change a frequency, and may obtain the current measurement information 520 regarding an output current pulse changing according to the frequency that changes. As another example, the processor may obtain the current measurement information 520 regarding the output current pulse of the pulse generator by using a certain current measurement sensor installed separately.

In some embodiments, the voltage measurement information 510 may include phase information and amplitude information regarding a voltage corresponding to a pulse, and the current measurement information 520 may include phase information and amplitude information regarding a current corresponding to the pulse.

In one or more embodiments, the processor may calculate an impedance value corresponding to the frequency on the basis of the voltage measurement information 510 and the current measurement information 520 corresponding to the output current pulse obtained in real time.

In some embodiments, the impedance value may be calculated by being divided into an imaginary part and a real part, the imaginary part may be calculated by using the phase information regarding the voltage and the phase information regarding the current, and the real part may be calculated by using the amplitude information regarding the voltage and the amplitude information regarding the current.

For example, the processor may obtain a phase difference *θ_{V} - θ_{I}* between the voltage and the current through a difference between a phase *θ_{V}* of the voltage and a phase *θ_{I}* of the current, and reactance may be determined according to the phase difference. In some embodiments, the processor may obtain a ratio |+*Vₘ*|/|+*Iₘ*| of the maximum amplitude *+Vₘ* of the voltage and the maximum amplitude *+Iₘ* of the current, and a magnitude of impedance may be determined according to the ratio.

In one or more advantageous embodiments, as described above, the processor may calculate an impedance value for each frequency by using the voltage measurement information 510 and the current measurement information 520.

For example, the processor may obtain battery state information on the basis of the calculated impedance value.

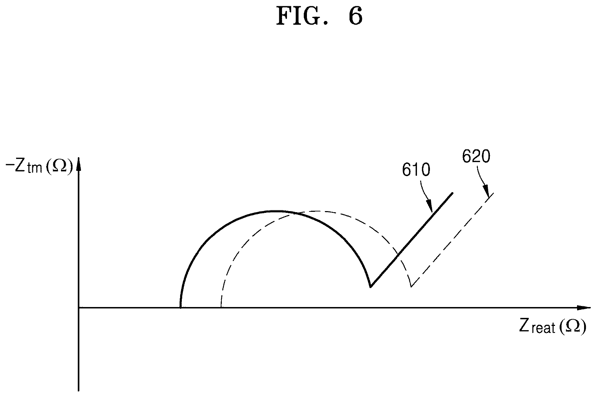

FIG. 6 is a view illustrating an example of a method of obtaining battery state information, according to one or more embodiments.

Hereinafter, an example of a method by which a processor obtains battery state information is described with reference to FIG. 6.

Referring to FIG. 6, a processor may derive a Nyquist graph 620 on the basis of an impedance value.

For example, the processor may derive a Nyquist graph 620 on the basis of a calculated impedance value, and may obtain battery state information on the basis of the result of comparing the derived Nyquist graph 620 with a pre-stored Nyquist graph 610.

In some embodiments, the Nyquist graph 620 may refer to a graph in which an impedance value calculated for EIS analysis is visualized according to a frequency, and electrochemical reactivity or resistance characteristics of a battery may be analyzed at a corresponding frequency by expressing a real part and an imaginary part on a coordinate plane. In some embodiments, the Nyquist graph 620 may be derived in a semicircle shape in a high frequency domain and a straight line shape in a low frequency domain, an x-axis may refer to a resistance component, and a y-axis may refer to a capacitance component.

In some embodiments, the pre-stored Nyquist graph 610 may refer to a graph derived on the basis of a theoretical impedance value (e.g., an optimal impedance value) of a battery cell 10.

For example, the processor may compare the Nyquist graph 620 derived on the basis of the impedance value calculated in real time with a Nyquist graph 610 derived on the basis of a prestored theoretical impedance value.

In one or more embodiments, the processor may obtain battery state information by diagnosing a current state of a battery cell 10 from a portion at which the Nyquist graph 610 and the Nyquist graph 620 differs from each other on the basis of the result of the comparison. In some embodiments, the battery state information may include at least one of SOC information regarding the battery, SOH information regarding the battery, deterioration information regarding the battery, or internal resistance information regarding the battery.

For example, the SOC information regarding the battery may refer to a current charged state of the battery, the SOH information regarding the battery may refer to the life of the battery, and the processor may obtain the SOC information regarding the battery and the SOH information regarding the battery on the basis of a difference between sizes of semicircles or slopes of straight lines of the pre-stored Nyquist graph 610 and the derived Nyquist graph 620.

For example, the internal resistance information regarding the battery may refer to information related to a cause of an increase in an internal resistance of the battery, and the processor may obtain the internal resistance information regarding the battery on the basis of a difference between the sizes of the semicircles or locations of centers of the semicircles of the pre-stored Nyquist graph 610 and the derived Nyquist graph 620.

For example, the deterioration information regarding the battery may refer to information related to a temperature change if the battery is charged and discharged, and the processor may obtain the deterioration information regarding the battery on the basis of the difference between the sizes of the semicircles or the slopes of the straight lines of the pre-stored Nyquist graph 610 and the derived Nyquist graph 620. In some embodiments, the processor may determine that the degree of deterioration of the battery is high according to the degree of asymmetry of the semicircle of the derived Nyquist graph 620.

In some embodiments, the processor may obtain the battery state information corresponding to a corresponding frequency on the basis of an impedance value calculated differently for each corresponding frequency. In some embodiments, different impedance values may be calculated according to frequencies, and thus, the processor may obtain the battery state information corresponding to each frequency bandwidth that continuously changes.

In some embodiments, the processor may derive a battery equivalent circuit model on the basis of the calculated impedance value.

For example, the processor may obtain the battery state information by comparing the battery equivalent circuit model derived on the basis of the calculated impedance value with a battery equivalent circuit model derived on the basis of a prestored theoretical impedance value (e.g., an optimal impedance value).

For example, the processor may calculate a difference between at least one parameter included in the pre-stored battery equivalent circuit model and the derived battery equivalent circuit model, and may obtain the battery state information on the basis of the difference between respective the parameters of the pre-stored battery equivalent circuit model and the derived battery equivalent circuit model.

In some embodiments, the processor may obtain the battery state information by using a pulse of a corresponding frequency supplied to a plurality of battery modules. In some embodiments, by calculating the impedance value, the processor may obtain the battery state information by performing EIS analysis without being supplied with additional power to perform EIS analysis.

For example, the processor may perform the EIS analysis by using a current pulse that is output from a pulse generator.

As an additional example, the processor may provide an alarm to a user on the basis of the obtained battery state information.

For a preferred example, if the degree of deterioration of the battery exceeds a numerical value (e.g., preset numerical value), the processor may provide a "cease battery use" alarm (e.g., a battery use stop alarm) to the user. In some embodiments, the form of the alarm may include a message using an image output apparatus, a warning image, a warning alarm using a sound output apparatus, or the like, but the form of the alarm is not limited thereto. Thus, it is guaranteed that a complete failure of the battery can be prevented by reminding the user to change the battery.

On the basis of the method described above in the disclosure, EIS analysis may be performed by calculating an impedance value in real time at the same time as a battery is charged.

In some embodiments, the EIS analysis may be performed even without additional power consumption.

In some embodiments, an additional circuit design for performing the EIS analysis may not be needed, and thus, a space inside a battery may be secured or a battery having a smaller size may be produced, and costs may also be reduced.

According to one or more embodiments, EIS analysis may be performed by calculating an impedance value at the same time as a battery is charged with a current according to various frequencies even without separate additional power for EIS analysis.

In some embodiments, a plurality of battery modules may be charged by using one pulse generator without the EIS circuit design of each of the plurality of modules.

In some embodiments, the EIS circuit design of each of the plurality of modules may not be needed, and thus the degree of space use may be increased, and costs may also be reduced.

However, aspects obtainable by the disclosure are not limited to the aspects described above, and other aspects not mentioned may be clearly understood by those skilled in the art from the description of the disclosure described below.

The above-described method may be written as a program that may be executed on a computer and may be implemented in a general-purpose digital computer that operates the program by using a computer-readable recording medium. A structure of data used in the above-described method may be recorded on a computer-readable recording medium through various means. The computer-readable recording medium includes storage media, such as magnetic storage media (e.g., ROM, RAM, USB, floppy disk, hard disk, etc.) and optical readable media (e.g., CD-ROM, DVD, etc.).

Those skilled in the art related to the present disclosure may understand that the above-described method may be implemented in a modified form without departing from the essential characteristics of the above description. The provided methods should be considered in an illustrative sense rather than a restrictive sense, and the scope of rights should be defined by claims rather than by the foregoing description and should be construed as including all differences falling within the scope equivalent thereto.

## Claims

1. A method of obtaining battery state information, the method comprising:
Controlling (310) a pulse generator (400) to supply a pulse of a frequency to battery modules (410);
Calculating (320) an impedance value corresponding to the frequency at a same time a battery comprising the battery modules (410) is charged based on voltage measurement information (510) and current measurement information (520) corresponding to the pulse obtained in real time; and
Obtaining (330) the battery state information based on the impedance value.

2. The method as claimed in claim 1, further comprising continuously changing the frequency based on a user-defined value.

3. The method as claimed in claim 2, wherein the controlling the pulse generator (400) comprises:
generating a current pulse corresponding to the frequency continuously changing; and
supplying the current pulse to the battery modules (410).

4. The method as claimed in claims 1 to 3, wherein the voltage measurement information (510) corresponds to cells in the battery modules (410), and is obtained from an apparatus (200) configured to control the battery modules (410).

5. The method as claimed in claims 1 to **4,** wherein the obtaining the battery state information comprises:
deriving a Nyquist graph (620) based on the impedance value; and
obtaining the battery state information based on a result of comparing the Nyquist graph (620) with a stored Nyquist graph (610).

6. The method as claimed in claims 1 to 5, further comprising differently calculating impedance values comprising the impedance value for frequencies comprising the frequency.

7. The method as claimed in claims 1 to 6, wherein the battery state information corresponds to the pulse of the frequency supplied to the battery modules (410).

8. The method as claimed in claims 1 to 7, wherein the battery state information comprises at least one of state of charge, SOC, information regarding the battery, state of health, SOH, information regarding the battery, deterioration information regarding the battery, or internal resistance information regarding the battery.

9. A computer-readable recording medium having recorded thereon a program for causing a computer to execute a method of obtaining battery state information by:
Controlling (310) a pulse generator (400) to supply a pulse of a frequency to battery modules (410);
calculating (320) an impedance value corresponding to the frequency at a same time a battery comprising the battery modules (410) is charged based on voltage measurement information (510) and current measurement information (520) corresponding to the pulse obtained in real time; and
obtaining (330) the battery state information based on the impedance value.

10. An apparatus (200) for obtaining battery state information, the apparatus (200) comprising:
a memory (230) for storing at least one program; and
at least one processor (220) configured to execute the at least one program to:
control (310) a pulse generator (400) to supply a pulse of a frequency to battery modules (410);
calculate (320) an impedance value corresponding to the frequency based on voltage measurement information (510) and current measurement information (520) corresponding to the pulse obtained in real time at a same time as a battery is charged; and
obtain (330) the battery state information based on the impedance value.

11. The apparatus (200) as claimed in claim 10, wherein the frequency is continuously changed based on a user-defined value.

12. The apparatus (200) as claimed in claim 10 or 11, wherein the voltage measurement information (510) corresponds to cells in the battery modules (410), and is obtained from an apparatus (200) configured to control the battery modules (410).

13. The apparatus (200) as claimed in claims 10 to 12, wherein the at least one processor (220) is further configured to execute the at least one program to obtain the battery state information by using the pulse of the frequency supplied to the battery modules (410).

14. The apparatus (200) as claimed in claims 10 to 13, wherein the at least one processor (220) is further configured to execute the at least one program to obtain the battery state information corresponding to impedance values comprising the impedance value that are calculated differently for frequencies comprising the frequency.

15. The apparatus (200) as claimed in claims 10 to 14, wherein the at least one processor (220) is further configured to:
derive a Nyquist graph (620) based on the impedance value; and
obtain the battery state information based on a result of comparing the Nyquist graph (620) with a stored Nyquist graph (610).
